# EUROPEAN PATENT SPECIFICATION

(11) **EP 1 553 535 B1**
(45) Date of publication and mention of the grant of the patent: **23.01.2008**
(21) Application number: 04252098.1
(22) Date of filing: 08.04.2004
(51) Int. Cl.: G08B 25/08

(54) **Remote management system for building installations**
Fernverwaltungssystem für Installationen in Gebäuden
Système de gestion à distance pour l'installations d'immeubles

(30) Priority: 06.01.2004 KR 2004000721
(43) Date of publication of application: 13.07.2005
(73) Proprietor: SAMSUNG ELECTRONICS CO., LTD., Suwon-si, Gyeonggi-do (KR)
(72) Inventor: Tanabe, Takeshi, Suwon-si Gyeonggi-do (KR); Jeong, Sang-jin, Hwasung-si Gyeonggi-do (KR)
(74) Representative: Waddington, Richard

(56) References cited:
- US-A- 4 262 283
- US-A- 5 754 111
- US-B1- 6 400 265
- US-B1- 6 462 654

## Description

The present invention relates to a remote management system for building installations, and more particularly to a remote management building installations in which an engineer may rapidly confirm a malfunction of a building installation.

The remote management system for building installations is a system to remotely watch and control malfunctions and operations of a plurality of building installations.

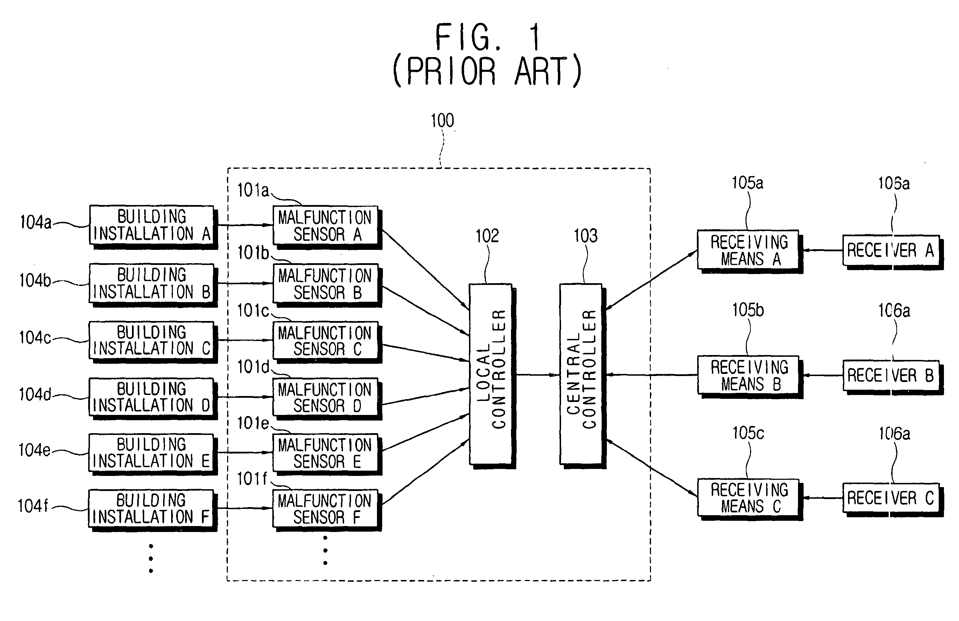

As shown in FIG. 1, a conventional remote management system for building installations 100 comprises a plurality of malfunction sensors 101a~101f, a local controller 102 and a central controller 103.

The malfunction sensors 101a~101f sense malfunctions of the building installations 104a~104f. Here, the building installations 104a~104f comprise all of installations providing a convenience for using the building such as doors, air cleaners, air conditioners, elevators, escalators and the like.

A sensing signal from each of the plurality of malfunction sensors 101a~101f is transmitted to the local controller 102, which transmits the malfunction message of the building installations 104a~104f to the central controller 103.

The central controller 103 transmits a malfunction message to a corresponding engineer who should check out and repair the malfunction of each of the building installations 104a~104f if the local controller 102 transmits the malfunction message to the central controller 40. Each of the engineers has a receiving means 105a~105c such as a telephone number, E-mail address or the like. The central controller 103 transmits the malfunction message to the receiving means of a proper engineer based on the malfunction message.
However, in the conventional remote management system for building installations 100, the central controller 103 doesn't recognize whether the engineer confirms the malfunction message. Further, if the engineer cannot obtain access to the receiving means 105a~105c, the central controller 103 cannot transmit the malfunction message to the engineer. Thus, a malfunction that should be urgently repaired may be neglected for a long time, which may cause a serious accident.

US 5,754,111 discloses a medical alerting system for sending a healthcare message to one or more recipients.

According to the present invention there is provided an apparatus and method as set forth in the appended claims. Preferred features of the invention will be apparent from the dependent claims, and the description which follows.

Accordingly, it is an aspect of the present invention to provide a remote management building installations in which a malfunction message can be transmitted to an engineer with efficiency.

The foregoing and/or other aspects of the present invention are achieved by a remote management system for building installations comprising:
at least one malfunction sensor to sense a malfunction of at least one building installation;
a local controller to transmit a malfunction message based on a sensing signal from the malfunction sensor;
a memory to store information on receivers to receive a predetermined malfunction message for each of the building installations and on receiving means of the receivers; and
a central controller to transmit the malfunction message to the receiving means of the prior order of a receiver of a building installation for which the malfunction message is transmitted, based on the memory, if the malfunction message is received from the local controller;
the receiving means being adapted for transmitting a receipt-confirmation information to the central controller if the receiver confirms the received malfunction message,
characterised in that the receiving means have an appointed receiving order and that the central controller is adapted for transmitting the malfunction message to the receiving means of the next order if the receiving means of the prior order does not transmit the receipt-confirmation information in a predetermined waiting time after the central controller transmits the malfunction message to the receiving means of the prior order

Preferably, the central controller waits for the receipt-confirmation information from the receiving means of the next order no more if the receiving means of the prior order transmits the receipt-confirmation information within the predetermined waiting time after the central controller transmits the malfunction message to the receiving means of the next order.

Preferably, the memory stores information on the receivers for each of the building installations, each of the receivers having an appointed receiving order, and the central controller transmits the malfunction message to the receiving means of the prior order for the receiver of the next order if all of the receiving means of the receiver of the prior order don't transmit the receipt-confirmation information.

Preferably, the central controller waits for the receipt-confirmation information from the receiver of the next order no more if the receiving means of the receiver of the prior order transmits the receipt-confirmation information within the predetermined waiting time after the central controller transmits the malfunction message to the receiving means of the receiver of the next order.

Preferably, the memory stores information on the receiver for each of the building installations, each of the receivers having an appointed receiving order, and the central controller transmits the malfunction message to the receiving means of the prior order for the receiver of the next order if all of the receiving means of the receiver of the prior order don't transmit the receipt-confirmation information.

Preferably, the central controller waits for the receipt-confirmation information from the receiver of the next order no more if the receiving means of the receiver of the prior order transmits the receipt-confirmation information within the predetermined waiting time after the central controller transmits the malfunction message to the receiving means of the receiver of the next order.

Preferably, the receiving means comprise a telephone, and the central controller transmits the malfunction message as a predetermined voice message to the telephone.

These and/or other aspects and advantages of the invention will become apparent and more readily appreciated from the following description of the preferred embodiments, taken in conjunction with the accompanying drawings of which:
FIG. 1 is a schematic block diagram showing a structure of a conventional remote management system for building installations;
FIG. 2 is a schematic block diagram showing a structure of a remote management system for building installations according to an embodiment of the present invention;
FIG. 3 shows a information data structure tree of receivers and receiving means each having an appointed receiving order to receive a malfunction message for each of building installations; and
FIG. 4 shows a information data structure tree of receivers each having an appointed receiving order and receiving means to receive a malfunction message per a building installation.

Reference will now be made in detail to the present preferred embodiments of the present invention, examples of which are illustrated in the accompanying drawings, wherein like reference numerals refer to the like elements throughout. The embodiments are described below in order to explain the present invention by referring to the figures.

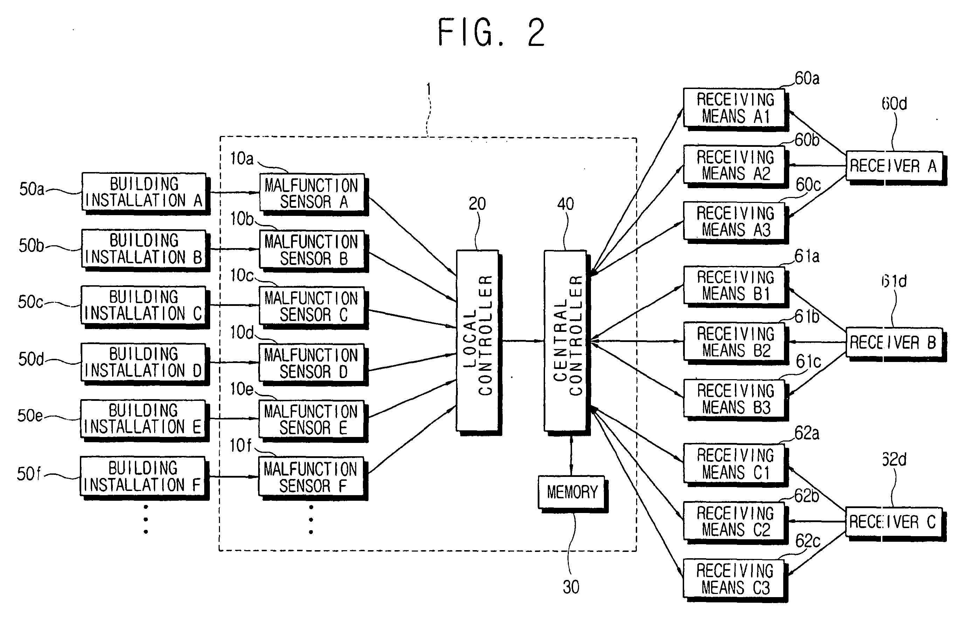

As shown in FIG. 2, a remote management system for building installations 1 according to an embodiment of the present invention comprises malfunction sensors 10a~10f, a local controller 20, a memory 30 and a central controller 40.

The malfunction sensors 10a~10f sense malfunctions of building installations 50a~50f and generate malfunction sensing signals if malfunctions are caused. Here, the building installations 50a~50f comprise all of installations providing a convenience for using the building such as doors, air cleaners, air conditioners, elevators, escalators and the like. Thus, the malfunction sensors 10a~10f may be implemented as a variety of devices according to a cause of the malfunction, a state of the malfunction of the building installations 50a~50f and the like. For example, malfunction sensors 10a~10f may be variously implemented as a switch, a temperature sensor, an air filter, a power supply sensor, a cutoff or the like according to the building installations 50a~50f.

The local controller 20 transmits a malfunction message based on sensing signals from the malfunction sensors 10a~10f. Here, the malfunction message may include a building installation in which malfunction is caused, malfunction symptoms and the like.

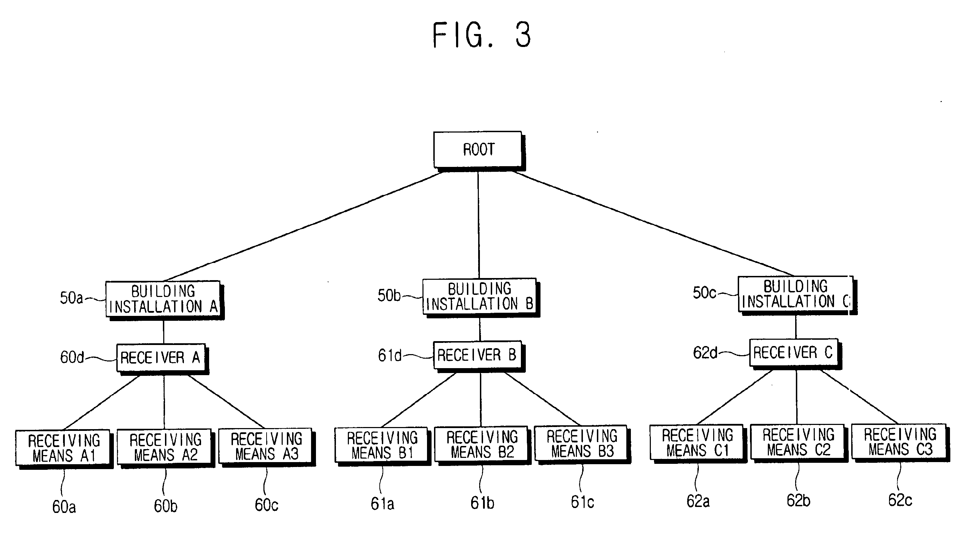

The memory 30 stores information including engineers and receiving means 60a~62c to receive the malfunction message if a malfunction is caused according to each of the building installations 50a~50f or each of the malfunction symptoms. As shown in a tree of FIG. 3, an engineer to check-out and repair each of the building installations 50a~50f is stored as a receiver 60d, 61d and 62d and receiving means 60a~62c are linked to the receivers 60d, 61d and 62d. Each of the receiving means 60a~62c has an appointed receiving order as a branch of the receivers 60d, 61d and 62d.

Here, each of the receiving means 60a~62c transmits a receipt-confirmation information if each of the receivers 60d, 61d and 62d confirms a predetermined malfunction message. A variety of receiving means may be employed for the receiving means 60a~62c according to a communication means. For example, if a malfunction message is transmitted by E-mail, the receiving means 60a~62c may be a computer terminal. If a malfunction message is received by a mobile communication means such as a cellular phone, the malfunction message may be transmitted through a short message service (SMS) or a voice message.

If the malfunction message is transmitted from the local controller 20, the central controller 40 searches a proper receiver among the receivers 60d, 61d and 62d and a receiving means of the prior order 60a, 61a, or 62a among the receiving means from the memory 30 and transmits the malfunction message to the receiving means of the prior order of the proper receiver. The receiving means of the prior order checks whether the receiver confirms the transmitted malfunction message. The receiving means of the prior order transmits the receipt-confirmation information to the central controller 40 if the receiver confirms the malfunction message.

The central controller 40 operates a timer after the central controller 40 transmits the malfunction message and checks whether the receipt-confirmation information is received in a predetermined waiting-time. If the receipt-confirmation information is not received in the predetermined waiting time, the central controller 40 searches a receiving means of the next order 60b, 61b or 62b. Then, the central controller 40 transmits the malfunction messaged to the searched receiving means.

At the receiving means of the next order 60b, 61b or 62b to which the malfunction message is transmitted, the same process as the above process is accomplished. If the receipt-confirmation information is not received by the receiving means of the next order 60b, 61b and 62b the central controller 40 transmits the malfunction message to the receiving means of the order after the next 60c, 61c and 62c.

While the central controller 40 is checking whether the receiving means of the next order or the order after the next transmits the receipt-confirmation information, the receipt-confirmation information from the receiving means of the prior order may be received to the central controller 40. Then, it is considered that a corresponding engineer receives the malfunction message and accordingly the receipt-confirmation information may be waited no more.

If the receipt-confirmation information is not received from all of receiving means for an engineer, the malfunction message may be transmitted to all of the receiving means for the engineer again. However, the retransmission of the malfunction message cannot guarantee a malfunction message confirmation of the engineer.

Thus, as an aspect of the present invention, the memory 30 may store classified information on receivers as a plurality of engineers having an appointed receiving order according to each of building installations 50a~50f or according to each of malfunction symptoms.

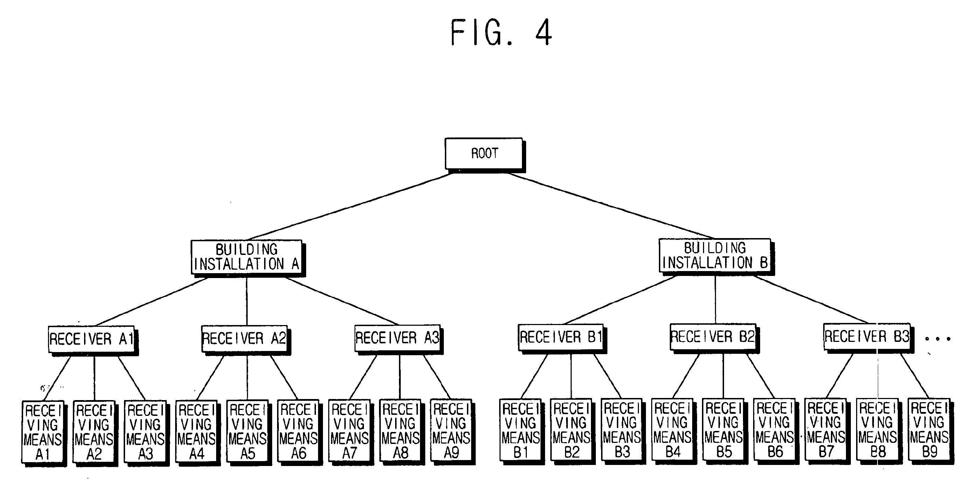

As shown in FIG. 4, the central controller 40 transmits the malfunction message to the receiver A1 corresponding to the receiving order of the building installation A. The central controller 40 transmits the malfunction message to the receiving means linked to the receiver A1 according to the receiving order.

If the receipt-confirmation information is not received from receiving means A3 of the lowest order, the central controller 40 searches a receiver the next order. The central controller 40 transmits the malfunction message to the receiving means of the next order receiver A2 according to the receiving order and the same process for the receiver of the prior order is repeated.

While the central controller 40 is waiting for the receipt-confirmation information from the receiver of the next order, the receipt-confirmation information may be received from the receiving means of the receiver of the prior order. Then, it is considered that the corresponding engineer receives the malfunction message and the receipt-confirmation information from the receiver of the next order is waited no more. It is required to inform the receiver of the next order of the normal transmission of the malfunction message to the receiver of the prior oder.

Information on receivers, receiving means and receiving order that are stored in the memory 30 may be changeable. For example, if the receiving means of a engineer is stored as a cellular phone and a phone number is changed, the central controller 40 receives the changed information and changes the data of the memory 30. Further, the receiving order of the engineers may be changed according to a service schedule.

The data stored according to each of building installations as shown in FIGS. 3 and 4 may be divided according to the malfunction symptoms. The application may be applied to the building installations at the same time.

According to the present invention, the engineer may rapidly confirm the malfunction of the building installations.

Although a few embodiments of the present invention have been shown and described, it would be appreciated by those skilled in the art that changes may be made in this embodiment without departing from the principles of the invention, the scope of which is defined in the claims and their equivalents.

## Claims

1. A remote management system for building installations comprising:
at least one malfunction sensor (10a-f) to sense a malfunction of at least one building installation (50a-f);
a local controller (20) to transmit a malfunction message based on a sensing signal from the malfunction sensor (10a-f);
a memory (30) to store information on receivers (60d, 61d, 62d) to receive a predetermined malfunction message for each of the building installations (50a-f) and on receiving means (60a-62c) of the receivers (60d, 61d, 62d); and
a central controller (40) to transmit the malfunction message to the receiving means (60a-62c) of the prior order of a receiver (60d, 61d, 62d) of a building installation (50a-f) for which the malfunction message is transmitted, based on the memory (30), if the malfunction message is received from the local controller (20);
the receiving means (60a-62c) being adapted for transmitting a receipt-confirmation information to the central controller (40) if the receiver (60d, 61d, 62d) confirms the received malfunction message,
**characterised in that** the receiving means (60a-62c) have an appointed receiving order and that the central controller (40) is adapted for transmitting the malfunction message to the receiving means (60a-62c) of the next order if the receiving means (60a-62c) of the prior order does not transmit the receipt-confirmation information in a predetermined waiting time after the central controller (40) transmits the malfunction message to the receiving means (60a-62c) of the prior order.

2. The remote management system for building installations according to claim 1, wherein the central controller (40) waits for the receipt-confirmation information from the receiving means (60a-62c) of the next order no more if the receiving means (60a-62c) of the prior order transmits the receipt-confirmation information within the predetermined waiting time after the central controller (40) transmits the malfunction message to the receiving means (60a-62c) of the next order.

3. The remote management system for building installations according to claim 1 or claim 2, wherein the memory (30) stores information on the receivers (60d, 61d, 62d) for each of the building installations, each of the receivers (60d, 61d, 62d) having an appointed receiving order, and
the central controller (40) transmits the malfunction message to the receiving means (60a-62c) of the prior order for the receiver (60d, 61d, 62d) of the next order if all of the receiving means (60a-62c) of the receiver (60d, 61d, 62d) of the prior order do not transmit the receipt-confirmation information.

4. The remote management system for building installations according to claim 3, wherein the central controller (40) waits for the receipt-confirmation information from the receiver (60d, 61d, 62d) of the next order no more if the receiving means (60a-62c) of the receiver (60d, 61d, 62d) of the prior order transmits the receipt-confirmation information within the predetermined waiting time after the central controller (40) transmits the malfunction message to the receiving means (60a-62c) of the receiver (60d, 61d, 62d) of the next order.

5. The remote management system for building installations according to claim 2, wherein the memory (30) stores information on the receiver (60d, 61d, 62d) for each of the building installations (50a-f), each of the receivers (60d, 61d, 62d) having an appointed receiving order, and
the central controller (40) transmits the malfunction message to the receiving means (60a-62c) of the prior order for the receiver (60d, 61d, 62d) of the next order if all of the receiving means (60a-62c) of the receiver of the prior order do not transmit the receipt-confirmation information.

6. The remote management system for building installations according to claim 5, wherein the central controller (40) waits for the receipt-confirmation information from the receiver (60d, 61d, 62d) of the next order no more if the receiving means (60a-62c) of the receiver (60d, 61d, 62d) of the prior order transmits the receipt-confirmation information within the predetermined waiting time after the central controller (40) transmits the malfunction message to the receiving means (60a-62c) of the receiver (60d, 61d, 62d) of the next order.

7. The remote management system for building installations according to any preceding claim, wherein the receiving means comprise a telephone, and
the central controller (40) transmits the malfunction message as a predetermined voice message to the telephone.

## Patentansprüche

1. Fernverwaltungssystem für Installationen in Gebäuden, umfassend:
wenigstens einen Fehlfunktionssensor (10a - f) zum Erfassen einer Fehlfunktion von wenigstens einer Installation (50a - f) in Gebäuden;
eine lokale Steuereinrichtung (20) zum Übertragen einer Fehlfunktionsnachricht auf Basis eines Erfassungssignals von dem Fehlfunktionssensor (10a - f);
einen Speicher (30) zum Speichern von Informationen über Empfänger (60d, 61d, 62d) zum Empfangen einer vorgegebenen Fehlfunktionsnachricht für jede der Installationen in Gebäuden und über Empfangseinrichtungen (60a - 62c) der Empfänger (60d, 61d, 62d); und
eine zentrale Steuereinrichtung (40), um auf Basis des Speichers (30) zu den Empfangseinrichtungen (60a - 62c) der vorherigen Reihenfolge eines Empfängers (60d, 61d, 62d) die Fehlfunktionsnachricht von einer Installation (50a - f) in Gebäuden zu übertragen, für welche die Fehlfunktionsnachricht übertragen wird, wenn die Fehifunktionsnachricht von der lokalen Steuereinrichtung (30) empfangen wird;
wobei die Empfangseinrichtungen (60a - 62c) dafür ausgelegt sind, eine Empfangsbestätigungsinformationen zu der zentralen Steuereinrichtung (40) zu übertragen, wenn der Empfänger (60d, 61d, 62d) die empfangene Fehlfunktionsnachricht bestätigt,
**dadurch gekennzeichnet, dass** die Empfangseinrichtungen (60a - 62c) eine festgelegte Empfangsreihenfolge aufweisen, und dass die zentrale Steuereinrichtung (40) dafür ausgelegt ist, die Fehlfunktionsnachricht zu den Empfangseinrichtungen (60a - 62c) der nächsten Reihenfolge zu übertragen, wenn die Empfangseinrichtungen (60a - 62c) der vorherigen Reihenfolge die Empfangsbestätigungsinformationen nicht in einer vorgegebenen Wartezeit überträgt, nachdem die zentrale Steuereinrichtung (40) die Fehlfunktionsnachricht zu dem Empfangseinrichtungen (60a - 62c) der vorherigen Reihenfolge überträgt.

2. Fernverwaltungssystem für Installationen in Gebäuden nach Anspruch 1, wobei die zentrale Steuereinrichtung (40) nicht mehr auf die Empfangsbestätigungsinformation von den Empfangseinrichtungen (60a - 62c) der nächsten Reihenfolge wartet, wenn die Empfangseinrichtungen (60a - 62c) der vorherigen Reihenfolge die Empfangsbestätigungsinformation innerhalb der vorgegebenen Wartezeit überträgt, nachdem die zentrale Steuereinrichtung (540) die Fehlfunktionsnachricht zu den Empfangseinrichtungen (60a - 62c) der nächsten Reihenfolge überträgt.

3. Fernverwaltungssystem für Installationen in Gebäuden nach Anspruch 1 oder Anspruch 2, wobei der Speicher (30) Informationen über die Empfänger (60d, 61d, 62d) für jede der Installationen in Gebäuden speichert, wobei jeder der Empfänger (60d, 61d, 62d) eine festgelegte Empfangsreihenfolge aufweist, und
die zentrale Steuereinrichtung (40) die Fehlfunktionsnachricht zu den Empfangseinrichtungen (60a - 62c) der vorherigen Reihenfolge für die Empfänger (60d, 61d, 62d) der nächsten Reihenfolge überträgt, wenn keine der Empfangseinrichtungen (60a - 62c) des Empfängers (60d, 61d, 62d) der vorherigen Reihenfolge die Empfangsbestätigungsinformation überträgt.

4. Fernverwaltungssystem für Installationen in Gebäuden nach Anspruch 3, wobei die zentrale Steuereinrichtung (40) nicht mehr auf die Empfangsbestätigungsinformation von dem Empfänger (60d, 61d, 62d) der nächsten Reihenfolge wartet, wenn die Empfangseinrichtungen (60a - 62c) des Empfängers (60d, 61d, 62d) der vorherigen Reihenfolge die Empfangsbestätigungsinformationen innerhalb der vorgegebenen Wartezeit überträgt, nachdem die zentrale Steuereinrichtung (40) die Fehlfunktionsnachricht zu den Empfangseinrichtungen (60a - 62c) des Empfänger (60d, 61d, 62d) der nächsten Reihenfolge überträgt.

5. Fernverwaltungssystem für Installationen in Gebäuden nach Anspruch 2, wobei der Speicher (30) Informationen über die Empfänger (60d, 61d, 62d) für jede der Installationen (50a - f) in Gebäuden speichert, wobei jeder der Empfänger (60d, 61d, 62d) eine festgelegte Empfangsreihenfolge aufweist, und
die zentrale Steuereinrichtung (40) die Fehlfunktionsnachricht zu den Empfangseinrichtungen (60a - 62c) der vorherigen Reihenfolge für die Empfänger (60d, 61d, 62d) der nächsten Reihenfolge überträgt, wenn keine der Empfangseinrichtungen (60a - 62c) des Empfängers der vorherigen Reihenfolge die Empfangsbestätigungsinformation überträgt.

6. Fernverwaltungssystem für Installationen in Gebäuden nach Anspruch 5, wobei die zentrale Steuereinrichtung (40) nicht mehr auf die Empfangsbestätigungsinformation von dem Empfänger (60d, 61d, 62d) der nächsten Reihenfolge wartet, wenn die Empfangseinrichtungen (60a - 62c) des Empfängers (60d, 61d, 62d) der vorherigen Reihenfolge die Empfangsbestätigungsinformationen innerhalb der vorgegebenen Wartezeit überträgt, nachdem die zentrale Steuereinrichtung (40) die Fehlfunktionsnachricht zu den Empfangseinrichtungen (60a - 62c) des Empfänger (60d, 61d, 62d) der nächsten Reihenfolge überträgt.

7. Fernverwaltungssystem für Installationen in Gebäuden nach einem beliebigen vorhergehenden Anspruch, wobei die Empfangseinrichtungen ein Telefon umfassen, und
die zentrale Steuereinrichtung (40) die Fehlfunktionsnachricht als eine vorgegebene Sprachnachricht zu dem Telefon überträgt.

## Revendications

1. Système de gestion à distance pour des installations de construction, comprenant :
au moins un capteur d'anomalie de fonctionnement (10a-f) pour détecter une anomalie de fonctionnement d'au moins une installation de construction (50a-f) ;
une unité de commande locale (20) pour émettre un message d'anomalie de fonctionnement en fonction d'un signal de détection provenant du capteur d'anomalie de fonctionnement (10a-f) ;
une mémoire (30) pour stocker des informations sur des récepteurs (60d, 61d, 62d) destinés à recevoir un message d'anomalie de fonctionnement prédéterminé pour chacune des installations de construction (50a-f) et sur des moyens de réception (60a-62c) des récepteurs (60d, 61d, 62d) ; et
une unité de commande centrale (40) pour émettre le message d'anomalie de fonctionnement en direction des moyens de réception (60a-62c) prioritaires dans l'ordre d'un récepteur (60d, 61d, 62d) d'une installation de construction (50a-f) pour laquelle le message d'anomalie de fonctionnement est émis, en fonction de la mémoire (30), si le message d'anomalie de fonctionnement est reçu en provenance de l'unité de commande locale (20) ;
les moyens de réception (60a-62c) étant adaptés pour émettre des informations de confirmation de réception en direction de l'unité de commande centrale (40) si le récepteur (60d, 61d, 62d) confirme le message d'anomalie de fonctionnement reçu ;
**caractérisé en ce que** les moyens de réception (60a-62c) présentent un ordre de réception désigné et **en ce que** l'unité de commande centrale (40) est adaptée pour émettre le message d'anomalie de fonctionnement en direction des moyens de réception (60a-62c) suivants dans l'ordre si les moyens de réception (60a-62c) prioritaires dans l'ordre n'émettent pas les informations de confirmation de réception dans un temps d'attente prédéterminé après que l'unité de commande centrale (40) émet le message d'anomalie de fonctionnement en direction des moyens de réception (60a-62c) de l'ordre précédent.

2. Système de gestion à distance pour des installations de construction selon la revendication 1, dans lequel l'unité de commande centrale (40) n'attend plus les informations de confirmation de réception en provenance des moyens de réception (60a-62c) suivants dans l'ordre si les moyens de réception (60a-62c) prioritaires dans l'ordre émettent les informations de confirmation de réception dans le temps d'attente prédéterminé après que l'unité de commande centrale (40) émet le message d'anomalie de fonctionnement en direction des moyens de réception (60a-62c) suivants dans l'ordre.

3. Système de gestion à distance pour des installations de construction selon la revendication 1 ou la revendication 2, dans lequel la mémoire (30) stocke des informations sur les récepteurs (60d, 61d, 62d) pour chacune des installations de construction, chacun des récepteurs (60d, 61d, 62d) ayant un ordre de réception désigné, et
l'unité de commande centrale (40) émet le message d'anomalie de fonctionnement en direction des moyens de réception (60a-62c) prioritaires dans l'ordre pour le récepteur (60d, 61d, 62d) suivant dans l'ordre si tous les moyens de réception (60a-62c) du récepteur (60d, 61d, 62d) prioritaire dans l'ordre n'émettent pas les informations de confirmation de réception.

4. Système de gestion à distance pour des installations de construction selon la revendication 3, dans lequel l'unité de commande centrale (40) n'attend plus les informations de confirmation de réception en provenance du récepteur (60d, 61d, 62d) suivant dans l'ordre si les moyens de réception (60a-62c) du récepteur (60d, 61d, 62d) prioritaire dans l'ordre émettent les informations de confirmation de réception dans le temps d'attente prédéterminé après que l'unité de commande centrale (40) émet le message d'anomalie de fonctionnement en direction des moyens de réception (60a-62c) du récepteur (60d, 61d, 62d) suivant dans l'ordre.

5. Système de gestion à distance pour des installations de construction selon la revendication 2, dans lequel la mémoire (30) stocke des informations sur le récepteur (60d, 61d, 62d) pour chacune des installations de construction (50a-f), chacun des récepteurs (60d, 61d, 62d) ayant un ordre de réception désigné, et
l'unité de commande centrale (40) émet le message d'anomalie de fonctionnement en direction des moyens de réception (60a-62c) prioritaires dans l'ordre pour le récepteur (60d, 61d, 62d) suivant dans l'ordre si tous les moyens de réception (60a-62c) du récepteur prioritaire dans l'ordre n'émettent pas les informations de confirmation de réception.

6. Système de gestion à distance pour des installations de construction selon la revendication 5, dans lequel l'unité de commande centrale (40) n'attend plus les informations de confirmation de réception en provenance du récepteur (60d, 61d, 62d) suivant dans l'ordre si les moyens de réception (60a-62c) du récepteur (60d, 61d, 62d) prioritaire dans l'ordre émet les informations de confirmation de réception dans le temps d'attente prédéterminé après que l'unité de commande centrale (40) émet le message d'anomalie de fonctionnement en direction des moyens de réception (60a-62c) du récepteur (60d, 61d, 62d) suivant dans l'ordre.

7. Système de gestion à distance pour des installations de construction selon l'une quelconque des revendications précédentes, dans lequel les moyens de réception comprennent un téléphone, et
l'unité de commande centrale (40) émet le message d'anomalie de fonctionnement comme un message vocal prédéterminé en direction du téléphone.
